# EUROPÄISCHE PATENTANMELDUNG

(11) **EP 0 817 540 A2**
(43) Veröffentlichungstag der Anmeldung: **07.01.1998**
(21) Anmeldenummer: 97110256.1
(22) Anmeldetag: 23.06.1997
(51) Int. Cl.: H05B 33/26

(54) **Eletrolumineszierende Anordnungen unter Verwendung von lamellaren Elektroden**

(30) Priorität: 05.07.1996 DE 19627069
(71) Anmelder: BAYER AG, 51368 Leverkusen (DE); Robert Bosch GmbH, 70469 Stuttgart (DE)
(72) Erfinder: Wehrmann, Rolf, Dr., 47800 Krefeld (DE); Jonas, Friedrich, Dr,, 52006 Aachen (DE); Elschner, Adreas, Dr., 45479 Mülheim a.d.Ruhr (DE); Hueppauff, Martin, Dr., 70563 Stuttgart (DE)
(74) Vertreter: Klimiuk-Japadita, Meike

(57) **Zusammenfassung**

Elektrolumineszierende Anordnung aus einem Substrat, einer Anode, einem elektrolumineszierenden Element und einer Kathode, wobei wenigstens eine der beiden Elektroden im sichtbaren Spektralbereich transparent ist und die Anode lamellar aus mindestens zwei dünnen Schichten aufgebaut ist, wobei die an den Träger angrenzende Schicht aus einem elektrisch leitfähigen, anorganischen Material mit einer beliebigen Elektronenaustrittsarbeit und die an das elektrolumineszierende Element angrenzende Schicht aus einem Material besteht, das elektrisch leitfähig ist und sich aus einer Lösung heraus deponieren läßt.

## Beschreibung

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht rekombinieren.

Bei der Entwicklung lichtemittierender Bauteile für Elektronik oder Photonik kommen heute hauptsächlich anorganische Halbleiter, wie Galliumarsenid, zum Einsatz. Auf Basis derartiger Substanzen können punktförmige Anzeigeelemente hergestellt werden. Großflächige Anordnungen sind nicht möglich.

Neben den Halbleiterleuchtdioden sind elektrolumineszierende Anordnungen auf Basis aufgedampfter niedermolekularer organischer Verbindungen bekannt (US-P 4 539 507, US-P 4 769 262, US-P 5 077 142, EP-A 406 762).

Weiterhin werden Polymere, wie Poly-(p-phenylene) und Poly-(p-phenylenvinylene (PPV)) als elektrolumineszierende Polymere beschrieben: G. Leising et al., Adv. Mater. 4 (1992) No. 1; Friend et al., J. Chem. Soc., Chem. Commun. 32 (1992); Saito et al., Polymer, 1990, Vol. 31, 1137; Friend et al., Physical Review B, Vol. 42, No. 18, 11670 oder WO 90/13148. Weitere Beispiele für PPV in Elektrolumineszenzanzeigen werden in EP-A 443 861, WO-A-9203490 und 92003491 beschrieben.

EP-A 0 294 061 stellt einen optischen Modulator auf Basis von Polyacetylen vor.

Zur Herstellung flexibler Polymer-LEDs haben Heeger at al. lösliche konjugierte PPV-Derivate vorgeschlagen (WO 92/16023).

Polymerblends unterschiedlicher Zusammensetzung sind ebenfalls bekannt: M. Stolka et al., Pure & Appt. Chem., Vol. 67, No. 1, pp 175-182, 1995; H. Bässler et al., Adv. Mater. 1995, 7, No. 6, 551; K. Nagai et al., Appl. Phys. Lett. 67 (16), 1995, 2281; EP-A 532 798.

Die organischen EL-Anordnungen enthalten in der Regel eine oder mehrere Schichten aus organischen Ladungstransportverbindungen. Der prinzipielle Aufbau in der Reihenfolge der Schichten ist wie folgt:
1 Träger, Substrat
2 Basiselektrode
3 Löcher-injizierende Schicht
4 Löcher-transportierende Schicht
5 Licht-emittierende Schicht
6 Elektronen-transportierende Schicht
7 Elektronen-injizierende Schicht
8 Topelektrode
9 Kontakte
10 Umhüllung, Verkapselung.

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordung aus zwei Elektroden, zwischen denen sich eine organische Schicht befindet, die alle Funktionen - inklusive der der Emission von Licht - erfüllt. Derartige Systeme sind z.B. in der Anmeldung WO 90/13148 auf der Basis von Poly-(p-phenylenvinylen) beschrieben.

Der Aufbau von Mehrschichtsystemen kann durch Aufdampfverfahren, bei denen die Schichten sukzessive aus der Gasphase aufgebracht werden oder durch Gießverfahren erfolgen. Gießverfahren sind aufgrund der höheren Prozeßgeschwindigkeiten bevorzugt. Allerdings stellt der Anlöseprozeß einer bereits aufgebrachten Schicht beim Überschichten mit der nächsten Schicht eine Schwierigkeit dar.

Die Aufgabe der vorliegenden Erfindung ist die Bereitstellung von lamellaren Basiselektroden, die die kostengünstige Herstellung von elektrolumineszierenden, organischen Schichtsystemen (O-LEDs) erlauben.

In den oben genannten Veröffentlichungen werden O-LEDs beschrieben, deren Basiselektrode aus transparenten, elektrisch leitfähigen Oxiden, wie z.B. Indium-Zinnoxid (ITO), oder aus semitransparenten Metallschichten, wie z.B. Gold, besteht. In der Regel wird für alle angeführten Beispiele ITO eingesetzt. ITO hat gegenüber den anderen Materialien den Vorteil, daß es eine relativ große Elektronenaustrittsarbeit besitzt (siehe z.B. I.D. Parker, J. Appl. Phys. 75, (1994), 1656-1666).

Da die Basiselektrode in der Regel als Anode geschaltet wird, müssen von der Anode her Löcher, d.h. positive Ladungsträger, in die angrenzende, organische Schicht injiziert werden. Dies gelingt umso besser, je größer die Elektronenaustrittsarbeit bzw. das Ionisationspotential ist (vgl. I.D. Parker, J. Appl. Phys. 75 (1994), 1656-1666).

Setzt man ITO als Basiselektrode ein, so treten folgende Nachteile auf:
a) Kommerziell erhältliches ITO besitzt rauhe Oberflächen und weist, bedingt durch den Herstellungsprozeß Spitzen (Sputtern) auf der Oberfläche auf.
b) Die Herstellung von ITO ist relativ teuer.
   (Zinnoxid ist ein vergleichsweise kostengünstigeres Material, das ebenfalls transparent und elektrisch leitfähig ist. Zinnoxid hat jedoch eine niedrigere Elektronenaustrittsarbeit und wird deshalb in der Regel nicht eingesetzt.)

Durch die rauhen Oberflächen von ITO treten bei O-LEDs häufig Kurzschlüsse auf, die in einer Fertigung einen hohen Ausschuß bedeuten. Daher müssen ITO-Substrate hoher Qualität und geringer Oberflächenrauhigkeit verwendet werden.

Die relativ hohen Kosten von ITO-beschichteten Substraten limitieren das Kostensenkungspotential von O-LEDs.

Die vorliegende Erfindung beschreibt eine lamellare Basiselektrode, mit der die oben genannten Schwierigkeiten gelöst werden können sowie die elektrolumineszierende Anordnung selbst.

Die erfindungsgemäße Basiselektrode besteht aus einer anorganischen Schicht, die direkt auf dem Träger aufgebracht ist und einer zweiten Schicht, die aus einer Lösung heraus mit Techniken wie z.B. Spin-Coating, Gießen, Rakeln, Cap-Coating etc., auf der ersten Schicht abgeschieden wird.

Die erste, anorganische Schicht besteht aus einem elektrisch leitfähigen Material, das transparent oder semitransparent ist. Hier können transparente Materialien, wie z.B. Indium-Zinnoxid (ITO), Zinnoxid, dotiertes Zinkoxid und weitere leitfähige Metalloxide, oder semitransparente Metallschichten, wie z.B. Au, Ag, Cu, Al, Cr, Ni oder Legierungen davon, eingesetzt werden. Diese Materialien müssen nicht notwendigerweise große Elektronenaustrittsarbeiten, wie z.B. ITO, besitzen. Dies ist für O-LEDs gemäß dem Stand der Technik, wie oben erwähnt, erforderlich.

Als zweite Schicht wird ein aus der Lösung deponierbares Material aufgetragen. Hier kommen transparente oder semitransparente Materialien wie z.B. Polymere oder Polymerblends in Frage. Bevorzugt werden elektrisch leitfähige Polymere wie Polythiophene, Polypyrrole, Polyanilin oder Polyacetylen verwendet. Besonders bevorzugt werden hier Polythiophene (z.B. Polyethylendioxythiophen/Polystyrolsulfonsäure-Na-Salz) eingesetzt. Die Materialien der zweiten Schicht müssen große Elektronenaustrittsarbeiten besitzen, um eine gute Löcherinjektion in das organische, elektrolumineszierende Schichtsystem zu ermöglichen. Vorzugsweise werden Materialien mit Elektronenaustrittsarbeiten größer als 4 eV, bevorzugt größer als 4,3 eV und besonders bevorzugt größer als 4,5 eV eingesetzt.

Um Inhomogenitäten des elektrischen Feldes innerhalb der lamellaren Basiselektrode zu vermeiden, muß das Material der zweiten Schicht einen spezifischen Widerstand aufweisen, der kleiner als 10¹¹ Ω cm, bevorzugt Kleiner als 10¹⁰ Ω cm und besonders bevorzugt kleiner als 10⁹ Ω cm ist.

Durch die Deposition der zweiten Schicht aus einer Lösung heraus ergibt sich eine sehr glatte, homogene Oberfläche der erfindungsgemäßen, lamellaren Basiselektrode, so daß Kurzschlüsse innerhalb der O-LED vermieden werden.

Inhomogenitäten der elektrischen Feldstärke würden zu Inhomogenitäten der Lichtemission der O-LEDs oder sogar zu Kurzschlüssen führen.

Die erfindungsgemäße Basiselektrode zeigt folgende Vorteile:
a) Es lassen sich leitfähige anorganische Materialien einsetzen, die sich mit kostengünstigen Herstellungsverfahren deponieren lassen, wie z.B. Sputtern, Aufdampfen (z.B. Metalle, Metalloxide, Legierungen), Hochratenspalten, CVD, naßchemische Depositionsverfahren (z.B. Sol-Gel-Materialien). Bei der Herstellung müssen nicht notwendigerweise Inhomogenitäten der Oberfläche vermieden werden.
b) Es können anorganische Materialien mit beliebigen Elektronenaustrittsarbeiten benutzt werden.
c) Die zweite Schicht kann in einem naßchemischen Prozeß deponiert werden. Dadurch ist eine kostengünstige Herstellung möglich.
d) Die naßchemisch deponierte, zweite Schicht weist extrem glatte Oberflächen auf, so daß es nicht zu Kurzschlüssen in der O-LED kommt.

### Beispiel 1

Elektrolumineszierende Anordnung auf Basis eines Blendsystems aus

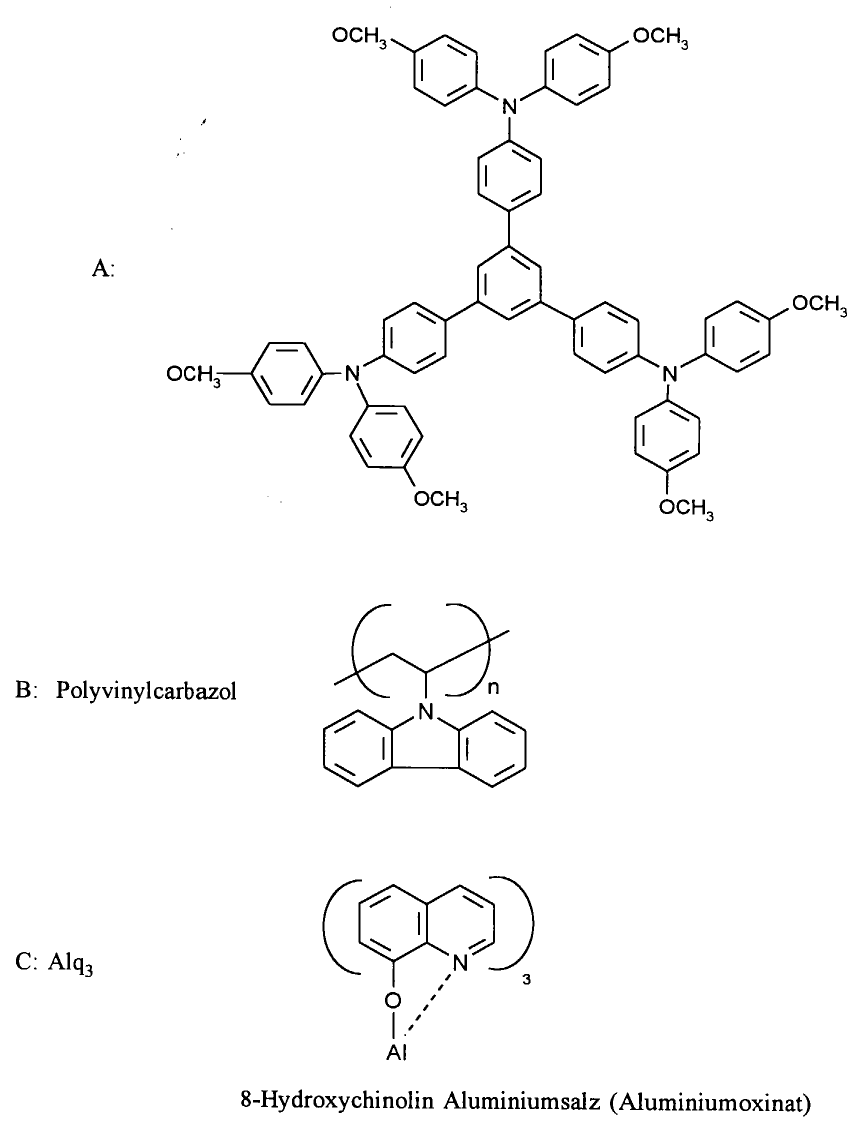

Eine 1 %ige Lösung bestehend aus 1 Gewichtsteil A, 4 Gewichtsteilen B und 1 Gewichtsteil C in Dichlorethan wird mit einem handelsüblichen Spincoater mit einer Umdrehungszahl von 400/min auf eine mit einer lamellaren Elektrode beschichteten Glasplatte verteilt.

Die lamellare Elektrode besteht aus einer ca. 100 nm dicken ITO-Schicht, auf die eine 74 nm dicke Schicht aus Polyethylendioxythiophen/Polystyrolsulfonsäure-Na-Salz (Baytron P, Bayer AG, Leverkusen, Deutschland) aufgeschleudert worden war. Die Beschichtung erfolgt gemäß den Angaben in EP-A 686 662. Allerdings wurde auf die dort beschriebene Wärmebehandlung verzichtet und das Substrat bei 80°C unter Stickstoff für 1 h getempert.

Die Schichtdicke des Blendsystems beträgt 100 nm.

Als Gegenelektrode wird Mg/Ag im Verhältnis 10:1 durch thermische Codeposition aufgebracht.

Nach Kontaktierung und Anlegen eines elektrischen Feldes zeigt die Anordnung ab etwa 8 V visuell erkennbare Elektrolumineszenz im grünen Spektralbereich. Die Helligkeit beträgt 89 cd/m² bei einem Strom von 19,1 mA/cm² und einer Spannung von 17 V.

Auf die Anordnung werden 16 Metallkontakte aufgedampft. Alle Kontakte funktionieren ohne Kurzschluß.

Die elektronischen Niveaus der Anordnung werden wie folgt bestimmt.

| | Austrittsarbeit | Bemerkung |
|---|---|---|
| ITO | 4,7 eV | [I.D. Parker] |
| PEDT/PSS Baytron P | 5,1 eV | eigene Messung (Kelvinsonde) |

### Beispiel 2

Elektrolumineszierende Anordnung auf Basis eines Blendsystems aus

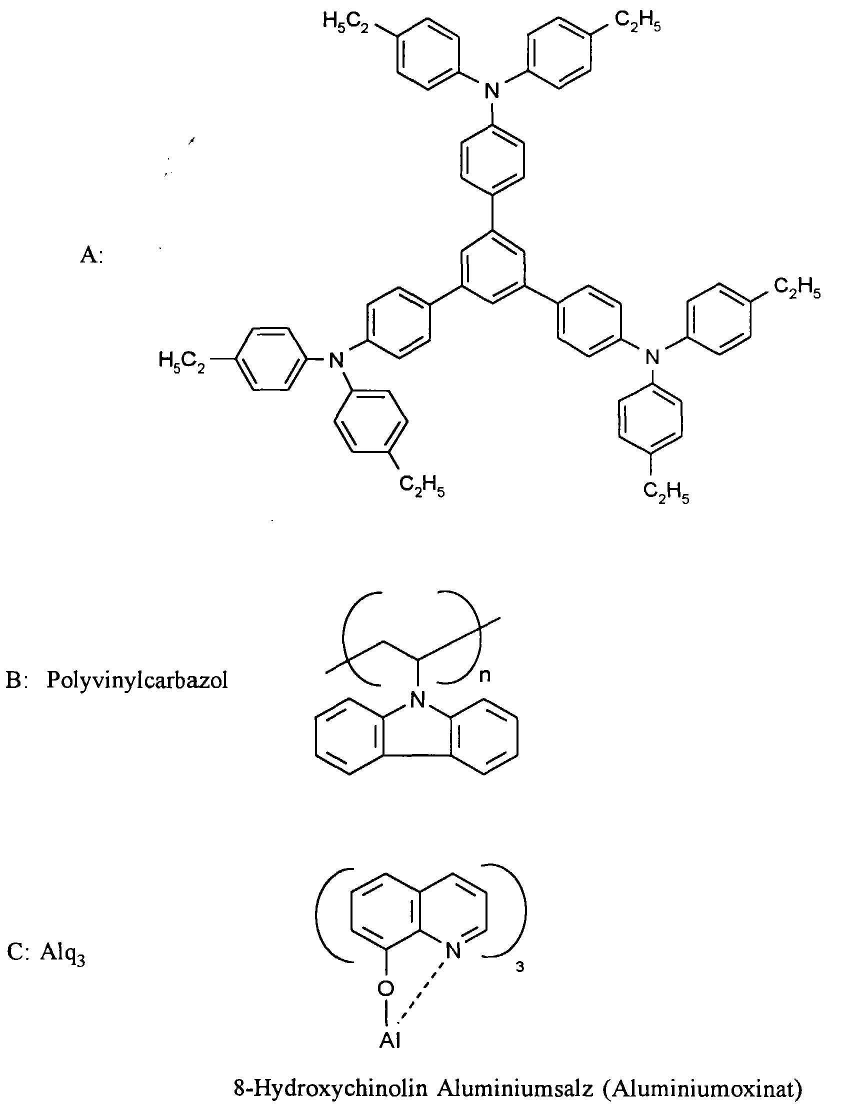

Eine 1 %ige Lösung bestehend aus 1 Gewichtsteil A, 1 Gewichtsteil B in Dichlorethan wird mit einem handelsüblichen Spincoater mit einer Umdrehungszahl von 800/min auf eine mit einer lamellaren Elektrode beschichteten Glasplatte verteilt und damit eine lochleitende Schicht hergestellt.

Die lamellare Elektrode besteht aus einer Zinnoxid-Schicht auf einem 4 mm Flachglas, auf die eine 74 nm dicke Schicht aus Polyethylendioxythiophen/Polystyrolsulfonsäure-Na-Salz aufgeschleudert worden war. Die Beschichtung erfolgt gemäß den Angaben in EP-A 686 662. Allerdings wurde auf die dort beschriebene Wärmebehandlung verzichtet und das Substrat bei 80°C unter Stickstoff für 1 h getempert.

Die Schichtdicke der lochleitenden Schicht beträgt ca. 70 nm. Auf diese lochleitende Schicht wird eine elektronenleitende bzw. emittierende Schicht bestehend aus Alq₃ bei 10⁻⁶ mbar aufgedampft. Die Schichtdicke beträgt ca. 60 nm.

Als Gegenelektrode wird eine MgAg-Legierung im Verhältnis 10:1 durch thermische Kodeposition aufgebracht. Das System emittiert grünes Licht. Die Helligkeit beträgt 550 Cd/m² bei einem Strom von 14 mA/cm² und einer Spannung von 12 Volt.

Die Ionisationspotentiale bzw. die höchste besetzte Molekularbitale (HOMO) von typischen, organischen Lochleitern liegen im Bereich von 5,1 bis 5,5 eV (siehe C. Adachi, K. Nagai, N. Tamoto, Appl. Phys. Lett. 66 (1995) 2679 - 2681).

Dies zeigt, daß aus der hier beschriebenen lamellaren Basiselektrode eine gute Lochinjektion in typische, lochleitende Materialien möglich ist.

## Patentansprüche

1. Elektrolumineszierende Anordnung aus einem Substrat, einer Anode, einem elektrolumineszierenden Element und einer Kathode, wobei wenigstens eine der beiden Elektroden im sichtbaren Spektralbereich transparent ist und die Anode lamellar aus mindestens zwei dünnen Schichten aufgebaut ist, wobei die an den Träger angrenzende Schicht aus einem elektrisch leitfähigen, anorganischen Material mit einer beliebigen Elektronenaustrittsarbeit und die an das elektrolumineszierende Element angrenzende Schicht aus einem Material besteht, das elektrisch leitfähig ist und das sich aus einer Lösung heraus deponieren läßt.

2. Elektrolumineszierende Anordnung gemaß Anspruch 1, dadurch gekennzeichnet, daß die an das elektrolumineszierende Element angrenzende Schicht eine Elektronenaustrittsarbeit von größer als 4 eV besitzt.

3. Elektrolumineszierende Anordnung gemäß Anspruch 1 und 2, dadurch gekennzeichnet, daß es sich bei der an das elektrolumineszierende Element angrenzenden Schicht aus Polyethylendioxithiophen (PEDT)/Polystyrolsulfonsäure-Salz handelt.

4. Verwendung der erfindungsgemäßen lamellaren Elektroden in elektrolumineszierenden Anordnungen.
